(19) **Europäisches Patentamt / European Patent Office / Office européen des brevets**

(11) **EP 4 524 287 A1**

(12) **EUROPEAN PATENT APPLICATION**
published in accordance with Art. 153(4) EPC

(43) Date of publication:
**19.03.2025 Bulletin 2025/12**

(21) Application number: **23845906.9**

(22) Date of filing: **24.03.2023**

(51) International Patent Classification (IPC):
**C23C 16/455** $^{(2006.01)}$ **C23C 16/24** $^{(2006.01)}$
**C23C 16/52** $^{(2006.01)}$ **H01L 21/205** $^{(2006.01)}$

(52) Cooperative Patent Classification (CPC):
**C23C 16/24; C23C 16/455; C23C 16/52;
H01L 21/2015**

(86) International application number:
**PCT/JP2023/012014**

(87) International publication number:
**WO 2024/024166 (01.02.2024 Gazette 2024/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.07.2022 JP 2022118692**

(71) Applicant: **Kokusai Electric Corporation
Tokyo 101-0045 (JP)**

(72) Inventors:
• **SHIKIDA, Gen**
  **Toyama-shi, Toyama 939-2393 (JP)**
• **KUDO, Toshio**
  **Toyama-shi, Toyama 939-2393 (JP)**
• **ITATANI, Hideharu**
  **Toyama-shi, Toyama 939-2393 (JP)**

(74) Representative: **Bardehle Pagenberg
Partnerschaft mbB
Patentanwälte Rechtsanwälte
Prinzregentenplatz 7
81675 München (DE)**

(54) **SUBSTRATE PROCESSING METHOD, METHOD FOR PRODUCING SEMICONDUCTOR DEVICE, SUBSTRATE PROCESSING APPARATUS, AND PROGRAM**

(57) The present invention provides a technology which enables the improvement of the film quality of a film that is formed on a substrate. A substrate processing method according to the present invention comprises a step in which a multilayer film that has a predetermined thickness is formed on a substrate by performing a cycle a predetermined number of times, the cycle comprising (a) a step in which a first film is deposited by exposing the substrate to a starting material gas, and (b) a step in which the substrate is exposed to a crystal growth inhibitor gas or a specific gas that forms a film having a film quality which is different from the film quality of the first film. With respect to this substrate processing method, the predetermined number of times is set so that the absolute value or gradient of the residual stress of the multilayer film after annealing of the multilayer film is lower than an acceptable value.

FIG. 4A

400

300

200

# FIG. 4B

**Description**

TECHNICAL FIELD

The present disclosure relates to a method of processing a substrate, a method of manufacturing a semiconductor device, a substrate processing apparatus, and a program.

BACKGROUND

As a process of manufacturing a semiconductor device, a process of forming a polycrystalline film on a substrate may be often carried out (*see, e.g.,* Patent Documents 1 to 7).

[Prior Art Documents]

Patent Documents

Patent Document 1: Japanese laid-open publication No. 2020-43262
Patent Document 2: Japanese laid-open publication No. 2016-1760
Patent Document 3: Japanese laid-open publication No. 2009-81457
Patent Document 4: Japanese laid-open publication No. 2013-197307
Patent Document 5: Japanese laid-open publication No. 2009-147388
Patent Document 6: Japanese laid-open publication No. 2018-160516
Patent Document 7: International Publication No. 2022/064578 Pamphlet

SUMMARY

When forming a polycrystalline film on a substrate, a residual stress of the film may become large, and a quality of the film formed on the substrate may deteriorate.
The present disclosure provides a technique capable of improving a quality of a film formed on a substrate.
According to embodiments of the present disclosure, there is provided a technique that includes:

forming a multilayer film with a predetermined thickness on a substrate by performing a cycle a predetermined number of times, the cycle including:

(a) depositing a primitive film by exposing the substrate to a precursor gas; and
(b) exposing the substrate to a crystal growth inhibition gas or a predetermined gas that forms a film with a different film quality from the primitive film,

wherein the predetermined number of times is set such that an absolute value or a gradient of a residual stress of the multilayer film after annealing the multilayer film is smaller than an allowable value.

According to the present disclosure, it is possible to improve a quality of a film formed on a substrate.

BRIEF DESCRIPTION OF DRAWINGS

The accompanying drawings, which are incorporated in and constitute a part of the specification, illustrate embodiments of the present disclosure.

FIG. 1 is a schematic configuration view of a vertical process furnace 202 of a substrate processing apparatus suitably used in embodiments of the present disclosure, in which a portion of the process furnace is shown in a vertical cross section.
FIG. 2 is a schematic configuration diagram of a controller 121 of a substrate processing apparatus suitably used in embodiments of the present disclosure, in which a control system of the controller 121 is shown in a block diagram.
FIG. 3 is a diagram showing a flowchart of a substrate processing process of embodiments of the present disclosure.
FIG. 4A is a view showing a substrate cross section of Samples 1 and 2 formed by a substrate processing process of a comparative example, and FIG. 4B is a view showing a substrate cross section of Samples 3 and 4 formed by a substrate processing process of embodiments of the present disclosure.

FIG. 5 is a diagram showing a processing sequence in a film-forming process of embodiments of the present disclosure.

FIG. 6 is a diagram showing a SIMS analysis result of oxygen in a film of a substrate after a substrate processing process of embodiments of the present disclosure.

FIG. 7 shows a measurement results of a residual stress of a film formed on a substrate without and with an annealing step in a substrate processing process of embodiments of the present disclosure.

FIG. 8A is a view showing a substrate cross section of Samples 1 and 2 formed by a substrate processing process of a comparative example, and FIG. 8B is a view showing a substrate cross section of Samples 3 and 4 formed by a substrate processing process of embodiments of the present disclosure.

FIG. 9A is a view showing a cross-sectional TEM image of Sample 1 of Experiment 3. FIG. 9B is a view showing a cross-sectional TEM image of Sample 3 of Experiment 3.

FIG. 10A is a view showing a cross-sectional TEM image of Sample 2 of Experiment 3. FIG. 10B is a view showing a cross-sectional TEM image of Sample 4 of Experiment 3.

FIG. 11A is a diagram showing an XRD analysis result of a film on a substrate of Sample 2 of Experiment 3. FIG. 11B is a diagram showing an XRD analysis result of a film on a substrate of Sample 4 of Experiment 3.

FIG. 12A is a view showing a cross-sectional SEM image of Sample 2 of Experiment 4. FIG. 12B is a view showing a cross-sectional SEM image of Sample 4 of Experiment 4.

FIG. 13A is a view showing a cross-sectional TEM image that shows a range of cross-sectional EBSD analysis for Sample 2 of Experiment 4. FIG. 13B is a view showing a cross-sectional TEM image that shows a range of cross-sectional EBSD analysis for Sample 4 of Experiment 4.

FIG. 14 is an inverse pole figure orientation map obtained by cross-sectional EBSD analysis of Samples 2 and 4 of Experiment 4.

FIG. 15 is an inverse pole figure orientation map of Samples 2 and 4 of Experiment 4.

FIG. 16A is a SEM image of a cantilever made of Sample 2 of Experiment 4. FIG. 16B is a SEM image of a cantilever made of Sample 4 of Experiment 4.

FIG. 17 is a diagram showing a profile of displacement amounts of surfaces of the cantilevers of Samples 2 and 4 of Experiment 4.

DETAILED DESCRIPTION

<Embodiments of Present Disclosure>

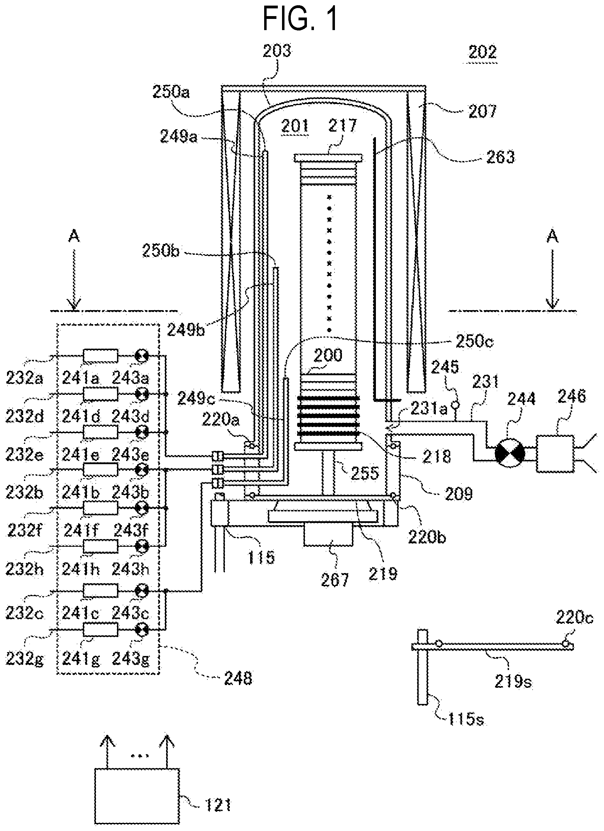

Embodiments of the present disclosure will now be described mainly with reference to FIGS. 1 to 5. Drawings used in the following description are schematic, and dimensional relationships, ratios, and the like among various components shown in the drawings may not match actual ones. Further, dimensional relationship, ratios, and the like of various components among a plurality of drawings may not match one another.

(1) Configuration of Substrate Processing Apparatus

As shown in FIG. 1, a process furnace 202 includes a heater 207 as a temperature regulator (a heating part). The heater 207 is formed in a cylindrical shape and is vertically installed by being supported by a support plate. The heater 207 also functions as an activator (an exciter) configured to thermally activate (excite) a gas.

A reaction tube 203 is disposed inside the heater 207 to be concentric with the heater 207. The reaction tube 203 is made of, for example, heat resistant material such as quartz ($SiO_2$) or silicon carbide (SiC), and is formed in a cylindrical shape with its upper end closed and its lower end opened. A manifold 209 is disposed under the reaction tube 203. The manifold 209 is made of, for example, metal material such as stainless steel (SUS), and is formed in a cylindrical shape with its upper and lower ends opened. The upper end of the manifold 209 is configured to engage with the lower end of the reaction tube 203 to support the reaction tube 203. An O-ring 220a serving as a seal is provided between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical area of the process container. The process chamber 201 is configured to be capable of accommodating wafers 200 as substrates. The wafers 200 are processed in the process chamber 201.

Nozzles 249a to 249c as first to third suppliers are respectively installed in the process chamber 201 so as to penetrate a sidewall of the manifold 209. The nozzles 249a to 249c are also referred to as first to third nozzles, respectively. The nozzles 249a to 249c are made of, for example, a heat resistant material such as quartz. Gas supply pipes 232a to 232c are connected to the nozzles 249a to 249c, respectively. The nozzles 249a to 249c are nozzles with different lengths.

The nozzle 249a is installed to extend in the process chamber 201 along a wafer arrangement direction to a position near an upper side of a wafer arrangement region from a lowermost wafer 200 to an uppermost wafer 200. The nozzle 249c is installed to extend to a position near a lower side of the wafer arrangement region along the wafer arrangement direction. The nozzle 249b is installed to extend to a position near a center of the wafer arrangement region. The nozzles 249a and 249c are installed adjacent to the nozzle 249b. Gas supply holes 250a to 250c configured to supply gases are formed at leading ends of the nozzles 249a to 249c, respectively.

Mass flow controllers (MFCs) 241a to 241c, which are flow rate controllers (flow rate control parts), and valves 243a to 243c, which are opening/closing valves, are installed at the gas supply pipes 232a to 232c, respectively, sequentially from an upstream side of a gas flow. Gas supply pipes 232d and 232e are respectively connected to the gas supply pipe 232a at the downstream side of the valve 243a. Gas supply pipes 232f and 232h are respectively connected to the gas supply pipe 232b at the downstream side of the valve 243b. A gas supply pipe 232g is connected to the gas supply pipe 232c at the downstream side of the valve 243c. MFCs 241d to 241h and valves 243d to 243h are installed at the gas supply pipes 232d to 232h, respectively, sequentially from an upstream side of a gas flow. The gas supply pipes 232a to 232h are made of, for example, a metal material such as SUS.

A precursor gas is supplied from the gas supply pipes 232a to 232c into the process chamber 201 via the MFCs 241a to 241c, the valves 243a to 243c, and the nozzles 249a to 249c, respectively. The precursor gas may also be referred to as a first element-containing gas containing a first element as a precursor.

A cleaning gas is supplied from the gas supply pipe 232d into the process chamber 201 via the MFC 241d, the valve 243d, and the nozzle 249a.

An inert gas is supplied from the gas supply pipes 232e to 232g into the process chamber 201 via the MFCs 241e to 241g, the valves 243e to 243g, the gas supply pipes 232a to 232c, and the nozzles 249a to 249c, respectively.

A crystal growth inhibition gas, which affects crystal growth of the precursor gas, is supplied from the gas supply pipe 232h into the process chamber 201 via the MFC 241h, the valve 243h, the gas supply pipe 232b, and the nozzle 249b.

A precursor gas supply system (also referred to as a film-forming gas supply system) mainly includes the gas supply pipes 232a to 232c, the MFCs 241a to 241c, and the valves 243a to 243c. A cleaning gas supply system mainly includes the gas supply pipe 232d, the MFC 241d, and the valve 243d. An inert gas supply system mainly includes the gas supply pipes 232e to 232g, the MFCs 241e to 241g, and the valves 243e to 243g. A crystal growth inhibition gas supply system mainly includes the gas supply pipe 232h, the MFC 241h, and the valve 243h.

Herein, since the precursor gas acts as a film-forming gas and a first element-containing gas, the precursor gas supply system may also be referred to as a film-forming gas supply system and a first element-containing gas supply system.

One or the entirety of the above-described various supply systems may be configured as an integrated supply system 248 in which the valves 243a to 243h, the MFCs 241a to 241h, and so on are integrated. The integrated supply system 248 is connected to each of the gas supply pipes 232a to 232h. In addition, the integrated supply system 248 is configured such that operations of supplying various kinds of gases into the gas supply pipes 232a to 232h (that is, opening/closing operations of the valves 243a to 243h, flow rate regulation operations by the MFCs 241a to 241h, and the like) are controlled by a controller 121 which will be described later. The integrated supply system 248 is configured as an integral or detachable integrated unit, and may be attached to or detached from the gas supply pipes 232a to 232h and the like on an integrated unit basis, such that maintenance, replacement, extension, and the like of the integrated supply system 248 may be performed on an integrated unit basis.

An exhaust port 231a configured to exhaust an internal atmosphere of the process chamber 201 is installed below the sidewall of the reaction tube 203. The exhaust port 231a is installed at a position opposing (facing) the nozzles 249a to 249c (the gas supply holes 250a to 250c) with the wafers 200 interposed therebetween. The exhaust port 231a may be installed at the sidewall of the manifold 209, or may be installed to extend from a lower side to an upper side of the sidewall of the reaction tube 203, that is, along the wafer arrangement region. An exhaust pipe 231 is connected to the exhaust port 231a. A vacuum pump 246 as an exhauster is connected to the exhaust pipe 231 via a pressure sensor 245, which is a pressure detector (pressure detection part) configured to detect an internal pressure of the process chamber 201, and an auto pressure controller (APC) valve 244, which is a pressure regulator (pressure regulating part). The APC valve 244 is configured to be capable of performing or stopping a vacuum exhausting operation in the process chamber 201 by opening/closing the valve while the vacuum pump 246 is actuated, and is also configured to be capable of regulating the internal pressure of the process chamber 201 by adjusting a degree of valve opening based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219, which serves as a furnace opening lid configured to be capable of hermetically sealing a lower end opening of the manifold 209, is installed under the manifold 209. The seal cap 219 is made of, for example, a metal material such as SUS, and is formed in a disc shape. An O-ring 220b, which is a seal making contact with the lower end of the manifold 209, is installed on an upper surface of the seal cap 219. A rotator 267 configured to rotate a boat 217, which will be described later, is installed under the seal cap 219. A rotary shaft 255 of the rotator 267 is connected to the boat 217 through the seal cap 219. The rotator 267 is configured to rotate the wafers 200 by rotating the boat 217. The seal cap 219 is configured to be vertically raised or lowered by a boat elevator 115 which is an elevator installed outside the reaction tube 203. The boat elevator 115 is configured as a transfer apparatus (transfer mechanism) configured to load or unload (transfer) the wafers 200 into or out of the process chamber 201 by raising or lowering the seal cap 219.

A shutter 219s, which serves as a furnace opening lid configured to be capable of hermetically sealing a lower end opening of the manifold 209 in a state where the seal cap 219 is lowered and the boat 217 is unloaded from the process chamber 201, is installed under the manifold 209. The shutter 219s is made of, for example, a metal material such as SUS, and is formed in a disc shape. An O-ring 220c, which is a seal making contact with the lower end of the manifold 209, is installed on an upper surface of the shutter 219s. The opening/closing operation (such as an elevating operation, a rotating operation, or the like) of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with centers of the wafers 200 aligned with one another. That is, the boat 217 is configured to arrange the wafers 200 to be spaced apart from each other. The boat 217 is made of, for example, a heat resistant material such as quartz or SiC. Heat insulating plates 218 are supported below the boat 217 in multiple stages.

A temperature sensor 263 serving as a temperature detector is installed in the reaction tube 203. Based on temperature information detected by the temperature sensor 263, a state of supplying an electric power to the heater 207 is regulated such that a temperature distribution inside the process chamber 201 becomes a desired temperature distribution. The temperature sensor 263 is installed along the inner wall of the reaction tube 203.

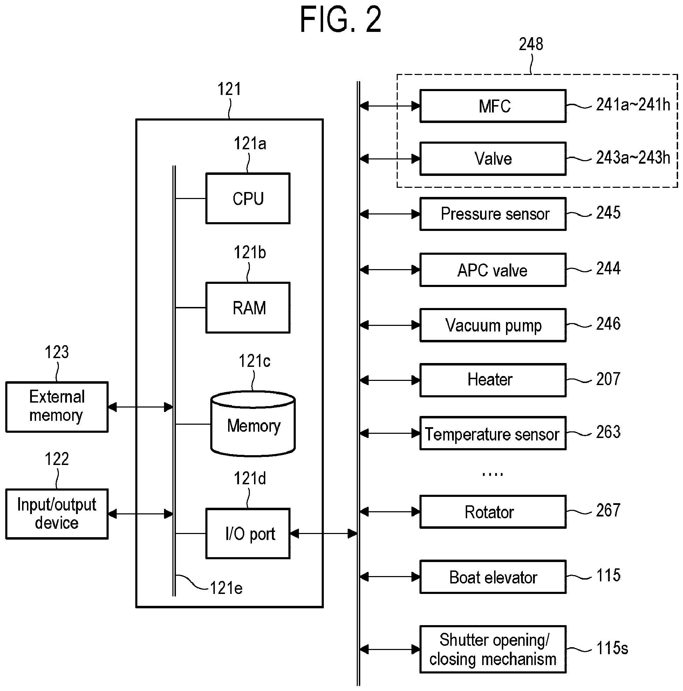

As shown in FIG. 2, a controller 121, which is a control part (control means or unit), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 including, e.g., a touch panel or the like, is connected to the controller 121.

The memory 121c includes, for example, a flash memory, a hard disk drive (HDD), a solid state drive (SSD), or the like. A control program that controls operations of a substrate processing apparatus, a process recipe in which sequences and conditions of substrate processing to be described later are written, etc. are readably stored in the memory 121c. The process recipe functions as a program that is combined to cause the controller 121 to execute each sequence in the substrate processing, which will be described later, to obtain an expected result. Hereinafter, the process recipe and the control program may be generally and simply referred to as a "program." Further, the process recipe may be simply referred to as a "recipe." When the term "program" is used herein, it may indicate a case of including the recipe, a case of including the control program, or a case of including both the recipe and the control program. The RAM 121b is configured as a memory area (work area) in which programs or data read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotator 267, the boat elevator 115, the shutter opening/closing mechanism 115s, and so on.

The CPU 121a is configured to be capable of reading and executing the control program from the memory 121c. The CPU 121a is also configured to be capable of reading the recipe from the memory 121c according to an input of an operation command from the input/output device 122. The CPU 121a is configured to be capable of controlling flow rate regulating operations of various kinds of gases by the MFCs 241a to 241h, opening/closing operations of the valves 243a to 243h, an opening/closing operation of the APC valve 244, a pressure regulating operation performed by the APC valve 244 based on the pressure sensor 245, an operation of actuating and stopping the vacuum pump 246, a temperature regulating operation performed by the heater 207 based on the temperature sensor 263, operations of rotating the boat 217 and adjusting a rotation speed of the boat 217 with the rotator 267, an operation of raising or lowering the boat 217 by the boat elevator 115, an opening/closing operation of the shutter 219s by the shutter opening/closing mechanism 115s, and so on, according contents of the read recipe.

The controller 121 may be configured by installing, on the computer, the aforementioned program stored in an external memory 123. Examples of the external memory 123 may include a magnetic disk such as a HDD, an optical disc such as a CD, a magneto-optical disc such as a MO, a semiconductor memory such as a USB memory or a SSD, and the like. The memory 121c or the external memory 123 is configured as a computer-readable recording medium. Hereinafter, the memory 121c and the external memory 123 may be generally and simply referred to as a "recording medium." Further, the program may be provided to the computer by using communication means or unit such as the Internet or a dedicated line, instead of using the external memory 123.

(2) Substrate Processing Process

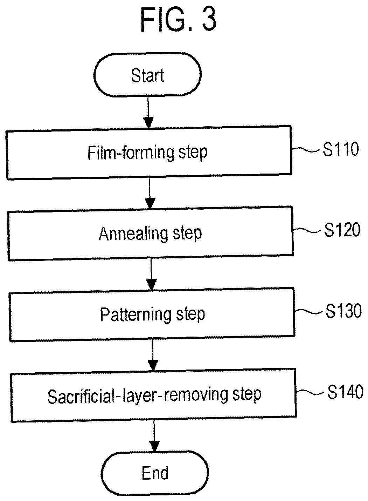

As a process of manufacturing a semiconductor device, an example of a processing sequence of forming a film on a surface of a wafer 200 by using the above-described substrate processing apparatus will be described mainly with reference to FIGS. 3, 4B, and 5. Herein, a sacrificial layer 300 is formed in advance on the surface of the wafer 200. In the following description, operations of the respective components constituting the substrate processing apparatus are controlled by the controller 121.

When the term "wafer" is used in the present disclosure, it may refer to "a wafer itself" or "a stacked body of a wafer and a certain layer or film formed on a surface of the wafer". When the phrase "a surface of a wafer" is used in the present disclosure, it may refer to "a surface of a wafer itself" or "a surface of a certain layer and the like formed on a wafer." When the expression "a certain layer is formed on a wafer" is used in the present disclosure, it may mean that "a certain layer is formed directly on a surface of a wafer itself" or that "a certain layer is formed on a layer and the like formed on a wafer". When the term "substrate" is used in the present disclosure, it may be synonymous with the term "wafer."

[Film-forming Step S110]

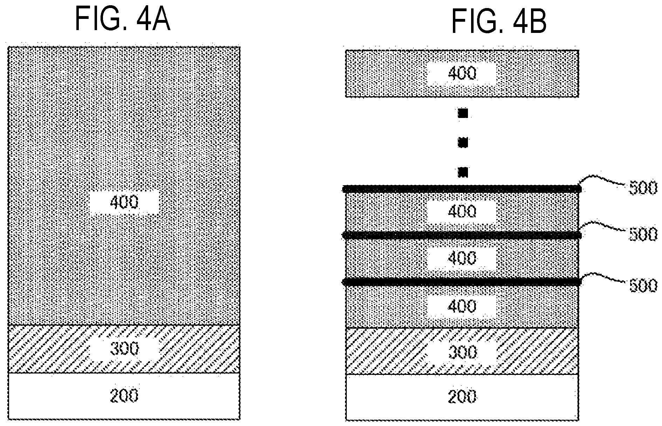

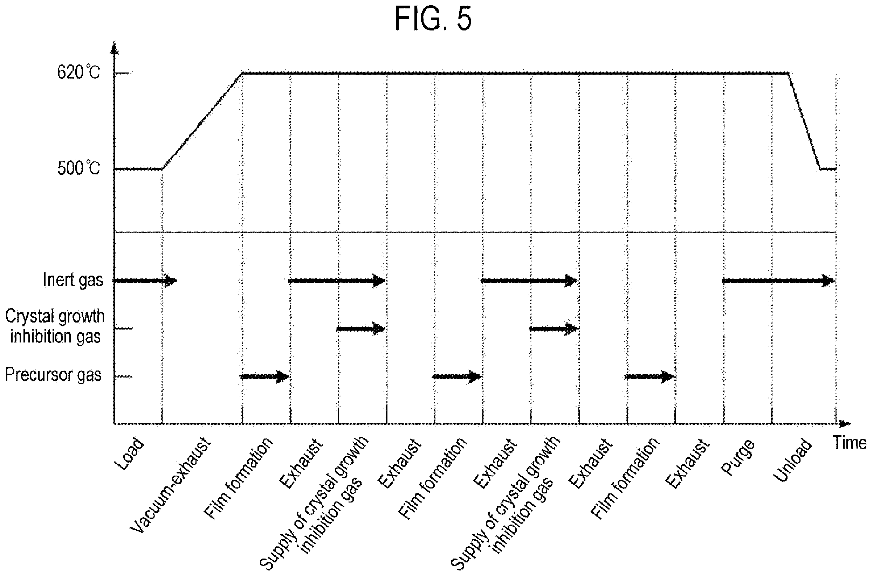

First, a film-forming step S110 will be described with reference to FIGS. 4B and 5. Herein, a precursor gas and a crystal growth inhibition gas are used, and a multilayer film is formed on the surface of the sacrificial layer 300 of the wafer 200 by alternately supplying these gases.

That is, the film-forming step includes:

step C of forming a multilayer film with a predetermined thickness on the wafer 200 by performing a cycle a predetermined number of times (n times, where n is an integer of 1 or more), the cycle including:

step A of depositing a polycrystalline film as a primitive film by exposing the wafer 200 to a precursor gas; and
step B of exposing the wafer 200 to a crystal growth inhibition gas,

wherein the predetermined number of times is set such that an absolute value or a gradient of a residual stress of the multilayer film after annealing the multilayer film is smaller than an allowable value.

In the above-described film-forming step, step B is performed under a condition in which a polycrystalline film deposited in the subsequent step A forms new crystal grains.

In the present disclosure, for the sake of convenience, the above-described processing sequence may be denoted as follows. The same denotation may be used in other embodiments, modifications, and the like to be described later.

(Precursor gas → Crystal growth inhibition gas) × n

(Wafer Charging and Boat Loading)

After the boat 217 is charged with a plurality of wafers 200 (wafer charging), the shutter 219s is moved by the shutter opening/closing mechanism 115s to open the lower end opening of the manifold 209 (shutter opening). Thereafter, as shown in FIG. 1, the boat 217 supporting the plurality of wafers 200 is lifted by the boat elevator 115 to be loaded into the process chamber 201 (boat loading), and finally the process chamber 201 is hermetically sealed by the seal cap 219. At this time, an inert gas is supplied into the process chamber 201, and the internal temperature of the process chamber 201 is maintained at a desired temperature.

(Vacuum Exhaust and Temperature Regulation)

Thereafter, an interior of the process chamber 201, that is, a space where the wafers 200 are placed, is vacuum-exhausted (decompression-exhausted) by the vacuum pump 246 to reach a desired pressure (degree of vacuum). In this operation, the internal pressure of the process chamber 201 is measured by the pressure sensor 245, and the APC valve 244 is feedback-controlled based on the measured pressure information. Further, the wafers 200 in the process chamber 201 are heated by the heater 207 so as to reach a desired processing temperature. At this time, a state of supplying the electric power to the heater 207 is feedback-controlled based on the temperature information detected by the temperature sensor 263 such that a temperature distribution inside the process chamber 201 becomes a desired temperature distribution. Further, rotation of the wafers 200 by the rotator 267 is started. The exhaust of the interior of the process chamber 201 and the heating and rotation of the wafers 200 are continuously performed at least until the processing on the wafers 200 is completed.

Thereafter, step A and step B are executed sequentially. Each of these steps will be described below.

[Step A]

In step A, a precursor gas is supplied to the wafer 200 in the process chamber 201, and the wafer 200 is exposed to the precursor gas to deposit (form) a polycrystalline film on the surface of the wafer 200. Then, the supply of the precursor gas is stopped and the precursor gas remaining in the process chamber 201 is exhausted (purged).

Specifically, the valves 243a to 243c are opened to allow the precursor gas to be supplied into the gas supply pipes 232a to 232c. A flow rate of the precursor gas is regulated by the MFCs 241a to 241c, and the precursor gas is supplied into the process chamber 201 via the nozzles 249a to 249c and is exhausted via the exhaust port 231a. In this operation, the wafer 200 is supplied with and exposed to the precursor gas. At this time, the internal pressure of the process chamber 201 is maintained at a predetermined processing pressure by the APC valve 244.

When the wafer 200 is supplied with (also referred to as being exposed to) the precursor gas under process conditions to be described below, a primitive film is deposited on the surface of the wafer 200 by a thermal CVD to form a polycrystalline film 400. The polycrystalline film 400 is, for example, a film containing a group XIV element. In the embodiments of the present disclosure, since a hot-wall-type batch process chamber is used, the CVD often involves a gas-phase reaction, in contrast to a cold-wall-type process chamber in which a surface reaction is a main reaction. A quality of the film obtained may differ depending on the type of process chamber. For example, a poly-Si film produced in a hot-wall-type low pressure CVD apparatus tend to be larger in compressive stress or stress gradient than an epi-poly-Si film produced in a cold-wall-type single wafer apparatus. A reaction intermediate supplied from the gas-phase reaction is useful when forming a high-quality film at a low temperatures, but it may produce excess atoms, which will be described later, to cause an increased residual stress.

The precursor gas may be a gas which causes the polycrystalline film 400 to be deposited on the wafer 200, and may be, for example, a gas containing a group XIV element, such as a Si-containing gas containing silicon (Si). For example, a monosilane ($SiH_4$)-containing gas may be used as the Si-containing gas. When a $SiH_4$ gas is used as the precursor gas, the $SiH_4$ gas is thermally decomposed in this step to form a polysilicon film, which is a polycrystalline film, on the surface of the wafer 200. In addition to the Si-containing gas, the precursor gas may also include a reducing gas, a carrier gas, and a dilution gas, such as a hydrogen ($H_2$) gas, a nitrogen ($N_2$) gas, a helium (He) gas, and an argon (Ar) gas.

Process conditions when supplying the precursor gas in step A are exemplified as follows:

Processing temperature: 400 to 1090 degrees C, specifically 500 to 750 degrees C,
Processing pressure: 1 to 100,000 Pa, specifically 10 to 1,000 Pa,
Supply flow rate of precursor gas: 10 to 5,000 sccm, specifically 100 to 1,500 sccm,
Deposition rate: 0.1 to 30 nm/min, specifically 1 to 20 nm/min, and
Supply flow rate of inert gas (for each gas supply pipe): 0 to 3,000 sccm.

At the end of step A, the valves 243a to 243c are closed to stop the supply of the precursor gas, and the interior of the process chamber 201 is vacuum-exhausted to remove the precursor gas and the like remaining in the process chamber 201 from the process chamber 201. At this time, an inert gas is supplied into the process chamber 201 via the nozzles 249a to 249c. The inert gas supplied from the nozzles 249a to 249c acts as a purge gas, whereby the interior of the process chamber 201 is purged (purging).

For example, a $N_2$ gas may be used as the inert gas, and other rare gases such as an Ar gas, a He gas, a neon (Ne) gas, and a xenon (Xe) gas may also be used as the inert gas. The same applies to each step to be described later.

Process conditions when performing the purging in step A are exemplified as follows:

Processing temperature: 400 to 1,090 degrees C, specifically the same temperature as when the precursor gas is supplied,
Processing pressure: 1 to 5,000 Pa, specifically 5 to 1,000 Pa,
Supply flow rate of inert gas (for each gas supply pipe): 0.1 to 5,000 sccm, and
Supply time of inert gas: 1 to 3,000 seconds.

In the present disclosure, notation of a numerical range such as "1,000 to 100,000 Pa" means that a lower limit value and an upper limit value are included in that range. Therefore, for example, "1,000 to 100,000 Pa" means "1,000 Pa or more and 100,000 Pa or less." The same applies to other numerical ranges. In the present disclosure, a processing temperature means a temperature of the wafer 200 or an internal temperature of the process chamber 201, and a processing pressure means an internal pressure of the process chamber 201. Further, a processing time means a time during which a process is continued. The same applies to the following description.

[Step B]

After step A is completed, step B is performed. In step B, a crystal growth inhibition gas and an inert gas are supplied to the wafer 200 in the process chamber 201. In other words, the wafer 200 with the polycrystalline film 400 formed on the surface of the wafer 200 is exposed to the crystal growth inhibition gas. As a result, a crystal growth inhibition layer (also referred to as a crystal growth inhibition film) 500 is formed on the surface of the wafer 200 on which the polycrystalline film is formed. Thereafter, the supply of the crystal growth inhibition gas and the inert gas is stopped to exhaust a gas remaining in the process chamber 201.

Specifically, the valve 243h is opened to allow the crystal growth inhibition gas to be supplied into the gas supply pipe 232b. A flow rate of the crystal growth inhibition gas is regulated by the MFC 241h, and the crystal growth inhibition gas is supplied into the process chamber 201 via the nozzle 249b and is exhausted via the exhaust port 231a. In this operation, the wafer 200 on which the polycrystalline film is formed is supplied with and exposed to the crystal growth inhibition gas. At this time, the valves 243e to 243g are open to allow an inert gas is supplied into the process chamber 201 via the nozzles 249a to 249c, respectively.

When the wafer 200 is supplied with and exposed to the crystal growth inhibition gas under the process conditions to be described below, for example, a crystal growth inhibition layer 500, which is a layer containing an element other than the element constituting the polycrystalline film, is formed on the surface of the polycrystalline film formed in the immediately preceding step A. The crystal growth inhibition layer 500 stops continuous crystal growth of microcrystals (crystal grains) constituting the polycrystalline film.

Step B is performed under conditions that allow a polycrystalline film deposited in the subsequent step A, which will be described later, to form new crystal grains. That is, by exposing the wafer 200, with the polycrystalline film formed on the surface of the wafer 200, to the crystal growth inhibition gas, the polycrystalline film deposited in the subsequent step A may form new crystal grains. In other words, step B is used as an opportunity to terminate crystal grain boundaries of the polycrystalline film formed on the surface of the wafer 200, and to provide crystal nuclei at a predetermined density to the polycrystalline film deposited in the subsequent step A, thereby growing crystals which are not continuous with underlying crystals. The crystal growth inhibition layer 500 may not be formed during step B, but may include an amorphous layer or other layer with a low crystallinity formed at the initial stage of the subsequent step A.

A thickness of the film or layer formed in step B is smaller than a thickness of the polycrystalline film formed in the immediately preceding step A, for example, 1/10 or less of the thickness of the polycrystalline film formed in the immediately preceding step A. Alternatively, step B may alter or remove a part of the film formed in the immediately preceding step A, or change (reconstruct) a surface state.

Next, the valve 243h and the valves 243e to 243g are closed to stop the supply of the crystal growth inhibition gas and the inert gas. Then, an interior of the process chamber 201 is vacuum-exhausted to remove a gas and the like remaining in the process chamber 201 from the process chamber 201.

Process conditions when supplying the crystal growth inhibition gas in step B are exemplified as follows:

Processing pressure: 1 to 10,000 Pa, specifically 1 to 1,000 Pa,
Supply flow rate of crystal growth inhibition gas: 0.1 to 5,000 sccm, specifically 10 to 500 sccm,
Supply time of crystal growth inhibition gas: 0.1 seconds to 30 minutes, specifically 1 second to 3 minutes, and
Supply flow rate of inert gas (for each gas supply pipe): 0 to 3,000 sccm.

Process conditions when performing the exhaust in step B are exemplified as follows:
Processing pressure: 0.1 to 5,000 Pa, specifically 10 to 1,000 Pa.

In addition, an output of the heater 207 is regulated such that step B is performed at the same processing temperature as step A.

For example, an oxygen (O)-containing gas or a nitrogen (N)-containing gas may be used as the crystal growth inhibition gas. For example, an oxygen ($O_2$) gas may be used as the O-containing gas. By using the O-containing gas as the crystal growth inhibition gas, at least a part of the polycrystalline film formed on the surface of the wafer 200 in step A is oxidized to form a layer containing O, which is an element other than the element constituting the polycrystalline film, and being different in a film quality from the polycrystalline film, on the surface of the polycrystalline film, thereby making it possible to inhibit a continuous crystal growth. In other words, the oxidized layer may be used as the crystal growth inhibition layer 500 that inhibits the crystal growth of the polycrystalline film.

In addition, in step B, when the O-containing gas is used as the crystal growth inhibition gas, the process is performed under a processing condition such that an oxygen (O) concentration of a film formed on the polycrystalline film after an annealing to be described later is less than $1 \times 10^{23}$ [atoms/cm$^3$]. Specifically, the process may be performed under such a condition that a peak value of an O concentration in a multilayer film before an annealing process is between $1 \times 10^{20}$ and $1 \times 10^{22}$ [atoms/cm$^3$]. Alternatively, the process is performed under such a condition that a density of the crystal nuclei formed due to step B becomes a desired density, for example, a density that causes a crystal grain size of the polycrystalline film formed thereon to be 1/5 or more of a crystal grain size when step B is not performed. This may be achieved by controlling an oxygen partial pressure, a processing temperature, a processing time, etc., when supplying the O-containing gas in step B. As a result, the O concentration in the multilayer film becomes very small as compared to its stoichiometric composition, and a decrease in crystal size is suppressed, such that an effect on properties of the multilayer film is limited.

[Step C]

By performing a cycle a predetermined number of times (n times, where n is an integer of 1 or more), the cycle including non-simultaneously performing the above-described steps A and B, a multilayer film with a predetermined thickness, for example, 1 μm or more, is formed on the surface of the sacrificial layer 300 of the wafer 200. The above-mentioned cycle may be performed a plurality of times. Specifically, by forming the crystal growth inhibition layer 500 every time the polycrystalline film 400 is formed such that a thickness of the polycrystalline film 400 reaches, for example, 250 nm, the multilayer film with a predetermined thickness, for example, 1 μm or more, is formed on the surface of the sacrificial layer 300 of the wafer 200. The steps A and B may be performed simultaneously.

Then, after step C, the above-described step A is performed to form the polycrystalline film 400 on the crystal growth inhibition layer 500. That is, the polycrystalline film 400 is deposited on the crystal growth inhibition layer 500 by forming new crystal grains. In other words, upper and lower polycrystalline films 400 sandwiching the crystal growth inhibition layer are formed with no or limited crystal continuity.

In this way, as shown in FIG. 4B, the crystal grains of the polycrystalline film 400 on the wafer 200 are divided by the crystal growth inhibition layer 500 to form the multilayer film that is the polycrystalline film 400 of multiple layers. A structure of the multilayer film thus formed is hereinafter also referred to as an inhibition layer inserted structure (ILIS), and a film-forming process to form such a structure is referred to as an ILIS process. In contrast, a conventional single film structure without ILIS as shown in FIG. 4A is referred to as a comparative example. After a multilayer film with a predetermined thickness, the above-mentioned predetermined number of times (also referred to as the number of times step B is performed, or the number of crystal growth inhibition layers) changes a density of amorphous or excess Si atoms, which will be described later, in the entire multilayer film. Therefore, by controlling the predetermined number of times, it is possible to control a residual stress in the entire multilayer film.

The above-mentioned predetermined number of times is set such that an absolute value of the residual stress in the multilayer film after the annealing process, which will be described later, is within a range of an allowable value. The allowable value of the residual stress in the film is, for example, -150 to 150 MPa, although it varies depending on an application. Herein, the stress is positive for a tensile stress and negative for a compressive stress. In other words, by controlling the number of times step B is inserted, the residual stress in the multilayer film after the annealing process may be controlled. Herein, the residual stress refers to a stress present in an object in the absence of an external force, and in the present disclosure, it may include both a force acting between the multilayer film and the wafer 200 that is a base of the multilayer film, and a stress remaining in the multilayer film even after the sacrificial layer is removed and a part of the above-mentioned residual stress is released. The residual stress may also be referred to as a film stress.

Herein, the number of times step B is performed in the film-forming process is set to be larger as the residual stress in the film after annealing becomes larger, and smaller as the residual stress in the film becomes smaller (i.e., larger on a compressive side). In other words, by controlling the number of times step B is performed, the residual stress in the multilayer film may be controlled, thereby alleviating the residual stress of the entire multilayer film.

In addition, by controlling the number of times step B is performed in the film-forming process, the residual stress in the multilayer film may be controlled, such that a stress control range is wider than when the number of times is fixed, and it is possible to make the residual stress close to zero even when a temperature in the annealing process to be described later is low (thermal history is small).

(After-Purge and Returning to Atmospheric Pressure)

Next, an inert gas is supplied into the process chamber 201 from each of the nozzles 249a to 249c and is exhausted via the exhaust port 231a. The inert gas supplied from the nozzles 249a to 249c acts as a purge gas, thereby purging the interior of the process chamber 201 and removing a gas, reaction by-products, and the like remaining in the process chamber 201 from the process chamber 201 (after-purge). Thereafter, the internal atmosphere of the process chamber 201 is replaced with the inert gas (inert gas replacement), and the internal pressure of the process chamber 201 is returned to the atmospheric pressure (returning to atmospheric pressure).

(Boat Unloading and Wafer Discharging)

Thereafter, the seal cap 219 is moved down by the boat elevator 115 to open the lower end of the manifold 209.

Then, the processed wafers 200 supported by the boat 217 are unloaded from the lower end of the manifold 209 to the outside of the reaction tube 203 (boat unloading). After the boat unloading, the shutter 219s is moved and the lower end opening of the manifold 209 is sealed by the shutter 219s via the O-ring 220c (shutter closing). The processed wafers 200 are unloaded from the reaction tube 203 and are then discharged from the boat 217 (wafer discharging).

Thereafter, in another process furnace (process chamber), boat loading and regulations of internal pressure and internal temperature of the process chamber are performed, and the next annealing step S120 is performed. That is, after the film-forming step S110 is completed, the annealing step is performed in a process furnace other than the process furnace used when the film-forming step is performed (ex-situ).

[Annealing Step S120]

Next, an annealing step S120 will be described. Herein, an annealing process is performed on the wafer 200 with the multilayer film formed on the surface of the wafer 200 under a non-plasma $N_2$ atmosphere. The annealing process converts the respective polycrystalline films, which are primitive films, into films with different film qualities. Specifically, the annealing process causes grain boundary migration and grain boundary sliding in the polycrystalline film, which often results in an increase in the crystal grain size. Further, amorphous Si present near the crystal grain boundary or in certain crystal growth inhibition layers may be integrated with adjacent crystal grains in a manner of solid phase epitaxial growth. As will be described later through a plurality of experiments, a ratio of excess Si in the entire multilayer film is considered to become higher and a shrink rate due to the annealing process becomes greater, as the number of times step B is performed becomes larger. Further, the residual stress shifts toward zero as compared with when the crystal growth inhibition layer 500 is not formed.

In step S120, the output of the heater is regulated such that the temperature of the wafer 200 is equal to or higher than the temperature of the wafer 200 in the film-forming step S110 and equal to or lower than 1,200 degrees C, more specifically, equal to or higher than 900 degrees C and equal to or lower than 1,100 degrees C. By setting the temperature in step S 120 to be lower than a maximum exposure temperature (typically, 1,100 to 1,200 degrees C) in annealing or the like during the manufacture of the wafer 200 (i.e., before the film-forming step S110), it is possible to suppress characteristics of the wafer 200, such as gettering sites and impurity concentration distribution, from being changed, and by setting the temperature to 1,000 degrees C or lower, it is possible to sufficiently suppress undesirable changes in the characteristics.

In step S120, as the predetermined number of times step C (the number of times step B is performed) in the above-described film-forming step S 110 becomes larger, the residual stress shifts from a compression of a negative value to a tension of a positive value. In a case where the residual stress after annealing when the predetermined number of times is 0 is a negative value, the absolute value of the residual stress in the multilayer film becomes smaller as the predetermined number of times increases from 0 until the residual stress is reversed to a positive value. In other words, the annealing step S120 is performed at a temperature of the wafer 200 including the multilayer film formed thereon at which properties of the multilayer film are changed such that a relationship between the number of times of step B in the above-described film-forming step S110 and the residual stress of the multilayer film after annealing becomes a positive correlation. A temperature rise rate and a temperature fall rate as well as the maximum temperature may affect the residual stress after annealing. In a case where the thickness of the multilayer film becomes greater than, for example, 10 $\mu$m, it may become difficult to anneal uniformly in a depth direction when using a method such as rapid thermal anneal (RTA).

In other words, in the annealing step S120, the absolute value of the residual stress of the multilayer film formed in the film-forming step S110 in which the number of times of step B is appropriately selected is made smaller than that before annealing, and the stress gradient is made smaller, such that the film quality may be improved. In this way, in the annealing step S120, it is possible to change the multilayer film into a film whose film quality is more improved than that before the annealing step, that is, a film with an enhanced film quality. In this context, the film quality may include a part or the entirety of crystallographic, chemical, mechanical, optical, and electrical properties of the film, as well as other properties demanded for device creation.

[Patterning Step S130]

Next, a patterning step S130 will be described. Herein, step S130 is performed in a process furnace different from the process furnace used in the film-forming step S110 and the annealing step S120. In step S130, patterning is performed on the wafer 200 after the annealing process.

The patterning step includes resist coating, exposure, anisotropic etching, resist removal, and the like.

[Sacrificial-Layer-Removing Step S140]

Next, a sacrificial-layer-removing step S140 of removing a sacrificial layer will be described. Herein, a step of removing the sacrificial layer from the wafer 200 after the patterning, by using different equipment from the film-forming step S110, the annealing step S120, and the patterning step S130, will be described.

As the sacrificial layer, for example, a silicon oxide ($SiO_2$) layer, a PSG layer containing phosphorus (P) in the $SiO_2$ layer, a boron phosphorus silicate glass (BPSG) layer, a Si layer, etc. may be used. The $SiO_2$ layer may be obtained by a CVD method in which tetraethoxysilane (TEOS) is used as a precursor, or by thermal oxidation of the wafer 200, etc. One or more of these layers may be used as the sacrificial layer.

In this step, the sacrificial layer formed as a base of the multilayer film on the wafer 200 is removed by a chemical reaction between an etching gas and the sacrificial layer. For example, a halogen-containing gas may be used as the etching gas. For example, a fluorine (F)-containing gas may be used as the halogen-containing gas. By using, for example, the halogen-containing gas as the etching gas, it is possible to remove the sacrificial layer formed on the wafer 200. For example, a hydrogen fluoride (HF) gas, a chlorine trifluoride ($ClF_3$) gas, a chlorine fluoride (ClF) gas, a nitrogen trifluoride ($NF_3$) gas, a fluorine ($F_2$) gas, etc. may be used as the F-containing gas which is an example of the halogen-containing gas. One or more of these gases may be used as the F-containing gas. The sacrificial layer may also be removed by a wet process which uses a hydrofluoric acid (HF) solution where nitric acid, acetic acid, and the like are added. In this case, in addition to water, a non-aqueous solvent such as hydrofluoroether may be used as a solvent.

Herein, when the sacrificial layer is removed to form a structure such as a cantilever, a polycrystalline film such as a polysilicon film formed on the sacrificial layer may warp in a direction perpendicular to the film. According to the present disclosure, the polycrystalline film may be processed into the cantilever while maintaining the stress gradient of the stress of the polycrystalline film in the depth direction within a predetermined range and reducing the absolute value of the residual stress in the film, thereby making it possible to suppress the warping of the film.

Further, this step may be performed by a dry etching as well as a wet etching.

(3) Effects of Embodiments of Present Disclosure

According to the embodiments of the present disclosure, one or more of effects set forth below may be achieved.

(a) By controlling the number of times the polycrystalline film on the wafer 200 is exposed to the crystal growth inhibition gas, it is possible to control the residual stress in the multilayer film. Further, it is possible to improve the film quality.

(b) By exposing the polycrystalline film on the wafer 200 to the crystal growth inhibition gas, it is possible to control the crystal grain size of the polycrystalline film. Specifically, regardless of an increase in the film thickness of the multilayer film, it is possible to improve the uniformity of the crystal grain size. Further, it is possible to obtain a film with a small surface roughness.

(c) Further, in the subsequent annealing step, it is possible to control the residual stress in the multilayer film within a desired range. Specifically, it is possible to reduce the absolute value or the stress gradient of the residual stress in the multilayer film after annealing.

(d) Further, in the subsequent annealing step, it is possible to control the stress gradient in the multilayer film within a desired range, and it is possible to improve the film quality as compared with the film quality before the annealing step. Specifically, it is possible to reduce the stress gradient in the multilayer film after annealing to a value smaller than an allowable value.

(e) Further, since no annealing is performed during the film-forming step and the processing temperature is not changed during the film-forming step, it is possible to shorten a processing time, making it possible to improve a throughput.

(f) Further, even in a case where the sacrificial layer formed as the base of the multilayer film on the wafer 200 is removed, the absolute value or the gradient of the residual stress in the multilayer film may be reduced, thereby making it possible to suppress warping of the multilayer film. Therefore, the above feature of the present disclosure may be suitably used when devices such as micro electro mechanical systems (MEMS) are manufactured.

(g) Further, a structure such as a MEMS inertial sensor may be fabricated by using a film formed by deposition. Any film such as an electrode layer may be inserted under the multilayer film via the sacrificial layer, and a degree of freedom in device design may be increased as compared with a silicon-on-insulator (SOI) process in which a SOI wafer or a cavity SOI wafer is used.

(h) Further, a film with a thickness of 20 to 30 $\mu$m and with a small absolute value or a small gradient of the residual stress may be formed by an LPCVD method, which is excellent in terms of a mass productivity.

(4) Modifications

Step B in the embodiments of the present disclosure may be changed as shown in the following modifications. Unless stated otherwise, processing procedures and process conditions in each step of each modification may be the same as the processing procedures and process conditions in each step of the above-described substrate processing sequence.

In this modification, instead of the crystal growth inhibition gas, a predetermined gas that forms a film or a surface with a different film quality from the polycrystalline film in step A is used in the above-described step B. That is, the above-described substrate processing apparatus includes a predetermined gas supply system configured to expose the wafer 200 in the process chamber 201 to a predetermined gas that forms a film with a different film quality from the polycrystalline film, and performs a processing sequence shown below.

(Precursor gas → Predetermined gas) × n

The predetermined gas is, for example, a gas containing a group XIV element. That is, the constituent element of the polycrystalline film in step A and the constituent element of the film with a different film quality from the polycrystalline film in step B may be substantially the same. For example, the film formed in step B may be different in crystallinity from the primitive film formed in step A but substantially the same in composition as the primitive film.

Specifically, for example, in step B, a silicon precursor gas other than the above-mentioned $SiH_4$ gas, such as a disilane ($Si_2H_6$) gas or a chlorosilane gas, may be supplied to form an amorphous Si film, which is a film with a different film quality from the polycrystalline film, on the surface of the polycrystalline film formed on the wafer 200 in step A. By using a precursor gas different from the precursor gas in step A, the crystallinity may be made different without changing a temperature.

This modification may also obtain the same effects as in the above-described embodiments. Further, in this modification, since a gas containing an element which is the same as the element contained in the precursor gas in step A is used in step B, it is possible to prevent the multilayer film from containing an element which is different from the element contained in the precursor gas.

Alternatively, steps A and B may be performed in parallel without being distinguished from each other. At this time, a predetermined gas different from the precursor gas is supplied together with the precursor gas such that sizes of crystal grains (cross-sectional areas in a plane parallel to the substrate) do not change and/or orientations of the crystal grains are the same, i.e., a crystallinity is constant, during deposition. At this time, a partial pressure of the precursor gas or a partial pressure of the predetermined gas exposed together with the precursor gas, or the temperature of the wafer 200 is changed. Even in this case, it is possible to maintain the gradient of the residual stress of the polycrystalline film within a predetermined range, and it is possible to process the polycrystalline film into the cantilever while maintaining the stress gradient of the polycrystalline film within a predetermined range. Herein, for example, an inert gas such as a $N_2$ gas or an Ar gas, or a $H_2$ gas may be used as the predetermined gas exposed together with the precursor gas.

<Other Embodiments of the Present Disclosure>

The embodiments of the present disclosure are specifically described above. However, the present disclosure is not limited to the above-described embodiments, and various changes may be made without departing from the gist thereof.

For example, in the above-described substrate processing process, steps S110 to S140 are each performed in a separate process furnace (process chamber) (i.e., an ex-situ process), but the present disclosure is not limited thereto, and the entirety or a part of the steps may be performed consecutively in the same process furnace (process chamber) (i.e., an in-situ process). The embodiments of the present disclosure may also obtain the same effects as in the above-described embodiments.

Further, for example, phosphine ($PH_3$) may be added (doped) to a Si-containing gas as the precursor gas used in step A to form a doped Si film as a polycrystalline film. This makes it possible to regulate a flow rate of a dopant gas for each nozzle and improve an inter-surface uniformity of an impurity concentration. Further, a crystal growth inhibition layer may be formed each time a doped Si film and a non-doped Si film in which $PH_3$ is not added to a Si-containing gas are formed, thereby forming a multilayer film. The embodiments of the present disclosure may also obtain the same effects as in the above-described embodiments.

Further, for example, a nitrogen (N)-containing gas (also referred to as a nitriding gas) may be used as the crystal growth inhibition gas used in step B. For example, a nitric oxide (NO) gas, an ammonia ($NH_3$) gas, N radicals, etc. may be used as the N-containing gas. Further, the N-containing gas may be activated by plasma or the like. As a result, at least a part of the polycrystalline film formed on the surface of the wafer 200 in step A is nitrided to form a layer containing N, which is an element other than the element constituting the polycrystalline film, on the surface of the polycrystalline film, such that the crystal grains of the polycrystalline film may be terminated. That is, a nitride layer may be used as the crystal growth inhibition layer for the polycrystalline film. These embodiments may also obtain the same effects as in the above-described embodiments.

Further, for example, the primitive film formed in step A is not limited to a polycrystalline film, but may be an amorphous film or a single crystal film. Further, the film formed in step B may be arbitrarily selected from a polycrystalline film, an amorphous films, etc. whose crystallinity is different from that of step A. In a case where the primitive film is an amorphous film, a laminated film may easily become polycrystallized by annealing at 600 degrees C or higher, and at that time, a process of step B may contribute to nucleation, grain boundary formation, and grain size control. Further, it is sufficient if a surface state of the film formed in step B is different from a surface state during step A at least in one atomic layer of the surface of the film, and the film may not be a continuous film. That is, step B is not limited to depositing a new film on the primitive film deposited in step A, but may be reconstructing a surface of the primitive film, causing specific molecules to be (sparsely) adsorbed on a very small part of the surface, modifying the surface by chemical reaction, breaking atomic bonds of the surface, or exciting the surface. These embodiments may also obtain the same effects as in the above-described embodiments of the present disclosure.

Further, in the above-described substrate processing process, a case where the multilayer film is formed on the wafer 200 on which the sacrificial layer is formed is described as an example, but the present disclosure is not limited thereto, and may be suitably applied even when the sacrificial layer is not directly in contact with the wafer 200 or even when the multilayer film is not directly in contact with the sacrificial layer. The sacrificial layer is not limited to a silicon oxide film, but may be a nitride film wafer, or may be either an amorphous film or a crystalline film. The $SiO_2$ film is usually amorphous, but may contain microcrystals with an orientation corresponding to the crystal orientation of the substrate, and in this case, a multilayer film formed thereon may also be formed with an orientation corresponding to the crystal orientation of the substrate.

Further, in the above-described substrate processing process, a case where the polycrystalline film is made of a single element semiconductor composed of Si is described as an example, but the present disclosure is not limited thereto, and may also be applied to mixed crystals such as SiGe, and compound semiconductors. Alternatively, the annealing process is not limited to raising a temperature of the entire multilayer film to a predetermined temperature, but may be performed by raising a temperature of a surface side of the multilayer film to a higher temperature by using a method such as RTA to cause a large shrinkage, thereby forming a stress gradient that causes the cantilever to warp upward. Further, the formation of the polycrystalline film is not limited to being performed by the thermal CVD, but may be performed by plasma CVD, photo CVD, reactive CVD, or any other film formation methods that may form a polycrystalline film.

Recipes used in each process may be provided individually according to the processing contents and may be stored in the memory 121c via a telecommunication line or the external memory 123. Moreover, at the beginning of each process, the CPU 121a may properly select an appropriate recipe from the recipes stored in the memory 121c according to the processing contents. Thus, it is possible for a single substrate processing apparatus to form films of various kinds, composition ratios, qualities, and thicknesses with enhanced reproducibility. Further, it is possible to reduce an operator's burden and to quickly start each process while avoiding an operation error.

The recipes mentioned above are not limited to newly-provided ones but may be provided, for example, by modifying existing recipes that are already installed in the substrate processing apparatus. Once the recipes are modified, the modified recipes may be installed in the substrate processing apparatus via a telecommunication line or a recording medium storing the recipes. In addition, the existing recipes already installed in the existing substrate processing apparatus may be directly modified by operating the input/output device 122 of the substrate processing apparatus.

An example in which a film is formed by using a batch-type substrate processing apparatus configured to process a plurality of substrates at a time is described in the above-described embodiments. The present disclosure is not limited to the above-described embodiments, but may be suitably applied, for example, to a case where a film is formed by using a single-wafer type substrate processing apparatus configured to process a single substrate or several substrates at a time. In addition, an example in which a film is formed by using a substrate processing apparatus provided with a hot-wall-type process furnace is described in the above-described embodiments. The present disclosure is not limited to the above-described embodiments, but may be suitably applied to a case where a film is formed by using a substrate processing apparatus provided with a cold-wall-type process furnace.

Even in the case of using these substrate processing apparatuses, each process may be performed according to the same processing procedures and process conditions as those in the above-described embodiments, and the same effects as those of the above-described embodiments may be obtained.

The above-described embodiments and modifications may be used in proper combination. The processing procedures and process conditions used in this case may be the same as, for example, the processing procedures and process conditions in the above-described embodiments and modifications.

(5) Below, several experimental results will be described.

(Experiment 1)

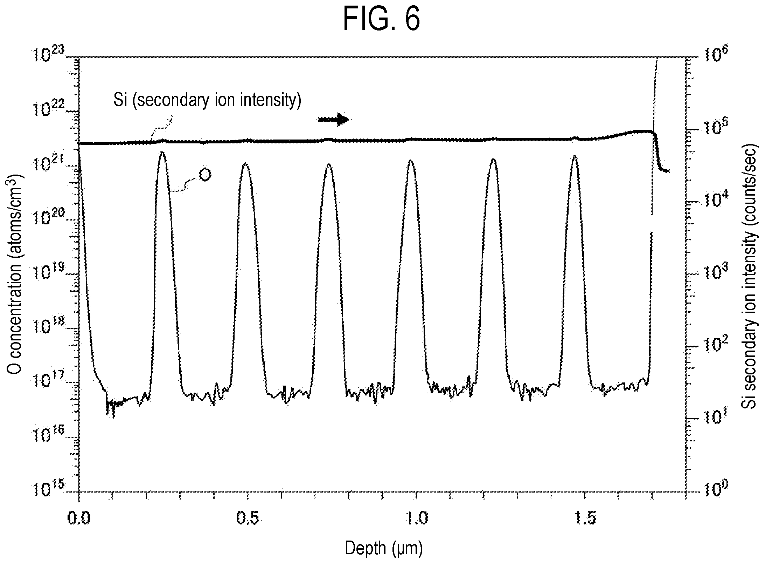

By using the above-described substrate processing apparatus, the above-described film-forming step (ILIS process) and annealing step are performed to provide an evaluation sample in which a multilayer film is formed on a sacrificial layer of a wafer. FIG. 6 is a diagram showing results of analyzing an O concentration in the film of the evaluation sample by secondary ion mass spectrometry (SIMS). Process conditions in the respective steps when providing the evaluation sample are set to predetermined process conditions within a range of the process conditions in the respective steps of the above-described embodiments. In FIG. 6, a horizontal axis represents a depth of the film, a right vertical axis represents a secondary ion intensity of Si, and a left vertical axis represents the O concentration. In addition, in the above-described step B, a process is performed under the process conditions in which the O concentration in the multilayer film after annealing when an $O_2$ gas is supplied as a crystal growth inhibition gas is less than $1\times10^{23}$[atoms/cm$^3$].

The oxygen (O) is the second most abundant element after Si in the composition of the film. It is confirmed that a peak value (maximum value) of the O concentration in the multilayer film after annealing is between $1\times10^{20}$ and $1\times10^{22}$ [atoms/cm$^3$]. Further, it is confirmed that a slop of the O concentration in the multilayer film when the $O_2$ gas is supplied is gentler than a slope of an O concentration in the interface of a SiO$_2$ layer which is the sacrificial layer. This is thought to be because a surface roughness (maximum height roughness) of the multilayer film is about 50 to 100 nm and O diffuses during film formation. Further, it is confirmed that a typical O concentration in a polycrystalline film after annealing is less than $1\times10^{17}$[atoms/cm$^3$]. This is smaller than a typical residual oxygen concentration of $1\times10^{18}$[atoms/cm$^3$] in a general Si wafer by using the current Czochralski method, and is smaller than a solid solubility limit of O. In addition, when a sample that is not subjected to an annealing step is also measured, there is no significant difference in an O concentration profile.

Therefore, it is confirmed that the O concentration in the multilayer film formed by the substrate processing process is very small and does not hinder satisfying a film quality demanded for a multilayer film for MEMS. In a case where the O concentration is $1\times10^{23}$[atoms/cm$^3$] or more, it may cause a decrease in crystal grain size and resistivity, such that the film quality demanded after annealing may not be satisfied, but in a case where the O concentration is $1\times10^{22}$ [atoms/cm$^3$] or less, the effect on the film quality is limited. Further, in a case where the O concentration is less than $1\times10^{20}$ [atoms/cm$^3$], the crystal growth inhibition effect is insufficient, such that new crystal grains may not be formed and a stress control may become difficult, but in a case where the O concentration is $1\times10^{20}$[atoms/cm$^3$] or more, the crystal growth inhibition effect sufficient for stress control may be obtained.

(Experiment 2)

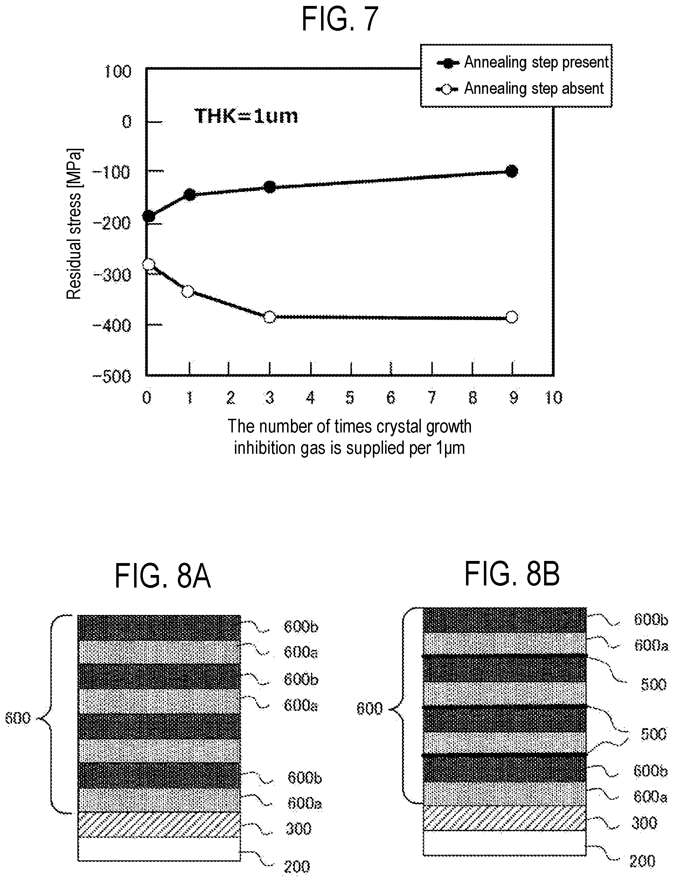

FIG. 7 is a diagram showing a relationship between the number of times the crystal growth inhibition gas is supplied and the residual stress in the film when the above-described ILIS process is performed by using the above-described substrate processing apparatus to form a multilayer film with a film thickness of 1 $\mu$m on a wafer, in comparison of a case where no annealing step is performed after forming the multilayer film with a case where an annealing step is performed after forming the multilayer film. In FIG. 7, a horizontal axis represents the number of times the crystal growth inhibition gas is supplied per 1 $\mu$m of film thickness, and a vertical axis represents the residual stress in the multilayer film. The residual stress with a minus sign indicates a compressive stress and the residual stress with a plus sign indicates a tensile stress. The internal stress of the multilayer film is evaluated by a substrate curvature method in which the multilayer film on one side of the substrate is peeled off after performing a film-forming process on both sides of the substrate and the warping of the substrate is measured. The number of times of 1, 3, and 9, respectively, means that a crystal growth inhibitor layer exists every 500 nm, 250 nm, and 100 nm increase in depth from the surface of the multilayer film.

In the absence of an annealing step, the residual stress in the multilayer film is generally negative (compressive stress). Further, it is confirmed that as the number of times the crystal growth inhibition gas is supplied becomes larger, the compressive stress becomes stronger.

In contrast, in the presence of an annealing process, the residual stress in the multilayer film is more shifted to a tensile side and the absolute value of the residual stress becomes smaller than in the absence of the annealing process at the entirety of the number of times the crystal growth inhibition gas is supplied. Further, it is confirmed that as the number of times the crystal growth inhibition gas is supplied becomes larger, the residual stress (compressive stress) moves more significantly in a tensile direction and approaches zero. In other words, it is confirmed that it is possible to reduce the absolute value of the residual stress in the multilayer film on the wafer depending on the number of times the crystal growth inhibition gas is supplied. In other words, dependency of the residual stress on the number of inhibition layers is reversed between the absence and the presence of the annealing step. This mechanism is considered as follows. First, shrinkage of the film may be considered as a reason that the residual stress is alleviated by the annealing process. Specifically, this is a model in which excess Si atoms present in the grain boundary are incorporated into the crystal. The excess Si is an amorphous silicon existing between the crystals, and is low in density because it is not crystallized. When the annealing process is performed, the amorphous part is crystallized, thereby reducing its volume, and the residual stress changes from a compressive side to a tensile side. In a case where a large compressive stress remains in an as-deposited film, the absolute value of the residual stress becomes smaller by annealing than before annealing.

Next, a difference in the number of grain boundaries may be considered as a reason that a tendency of depending on the number of inhibition layers differs before and after the annealing process. Herein, it is assumed that the size of the crystal grains in the polycrystalline film 400 increases as the deposition proceeds. Then, by increasing the number of inhibition layers, a thickness per one layer of the polycrystalline film decreases, and an average crystal grain size decreases. This leads to an increase in an area of the grain boundary and an increase in a proportion of excess atoms, and the residual stress of the as-deposited film increases in the compressive direction. On the other hand, when the annealing process is performed, a shrink rate increases as the number of inhibition layers increases, and the residual stress is significantly alleviated and changes to the tensile side. This model is further supported by Experiments 3 and 4 to be described later.

In other words, it is confirmed that the residual stress is alleviated by performing the annealing process as compared with the case where no annealing process is performed, and further, as the number of times the crystal growth inhibition gas is supplied becomes larger, the residual stress in the film is shifted from the compressive stress to the tensile stress, making it possible to bring the residual stress closer to zero. That is, it is confirmed that after the annealing process, properties of the multilayer film are changed so that as the number of times the crystal growth inhibition gas is supplied becomes larger, the residual stress in the film becomes larger, or the absolute value of the residual stress becomes smaller. In this way, by forming a multilayer film with a large compressive stress, i.e., an undesirable film quality, once due to the crystal growth inhibition layer, and then removing the cause of the compressive stress by annealing, a film with better film quality than a film without a crystal growth inhibition layer may be obtained.

In addition, in another experiment in which a film-forming process is performed at 620 degrees C and an annealing process is performed at 900 degrees C for one hour, a residual stress of substantially zero or slightly positive is confirmed after the annealing. Therefore, it is thought that the residual stress may be made to be even closer to zero or a tensile stress may be made to remain by further optimizing the temperature of the film-forming process and the temperature and time of the annealing process. Further, FIG. 7 suggests that a control range of the residual stress may be approximately doubled by including an option of not performing annealing (i.e., bringing the annealing temperature as close as possible to the film-forming temperature). For example, when a target stress is less than a predetermined stress, it is possible to control the stress in such a manner that the stress decreases as the number of sacrificial layers is increased without annealing, and when the target stress exceeds the predetermined stress, it is possible to control the stress in such a manner that the stress increases as the number of sacrificial layers is increased by annealing. This makes it possible to expand a control range of warp when a predetermined warp is to be given to a cantilever.

(Experiment 3)

In Experiment 3, 1 $\mu$m-multilayer films are formed, under two conditions, on both sides of a 200 mm-Si wafer with bases $SiO_2$ with a thickness of a 100 $\mu$m formed as sacrificial layers on both sides of the wafer by using the above-described substrate processing apparatus, and are evaluated by a cross-sectional transmission electron microscopy (TEM) observation and an X-ray diffraction (XRD). Herein, Samples 1 and 2 are fabricated under a first condition of the two conditions. That is, as shown in FIG. 8A, as a film-forming process of a comparative example, a process of forming a doped Si film 600a with a thickness of 25 nm on a sacrificial layer 300 by using a Si-containing gas added (doped) with $PH_3$ and a process of forming a non-doped Si film 600b with a thickness of 225 nm without being added with $PH_3$ are performed four times to form a polycrystalline film 600. Samples 3 and 4 are manufactured under a second condition. That is, as shown in FIG. 8B, a polycrystalline film 600 is formed by an ILIS process in which an $O_2$ gas is supplied to form a crystal growth inhibition layer (also referred to as an $O_2$ purge layer) 500 each time a process of forming a doped Si film 600a with a thickness of 25 nm on the sacrificial layer 300 by using a Si-containing gas added with $PH_3$ and a process of forming a non-doped Si film 600b with a thickness of 225 nm without being added with $PH_3$ are performed. In both conditions, the polycrystalline film is formed at a temperature of 620 degrees C, a phosphorus concentration in a phosphorus-doped Si film 600a is $1\times10^{20}$[cm$^{-3}$], and Samples 2 and 4 are annealed at 1,100 degrees C for 5 minutes in a $N_2$ gas atmosphere.

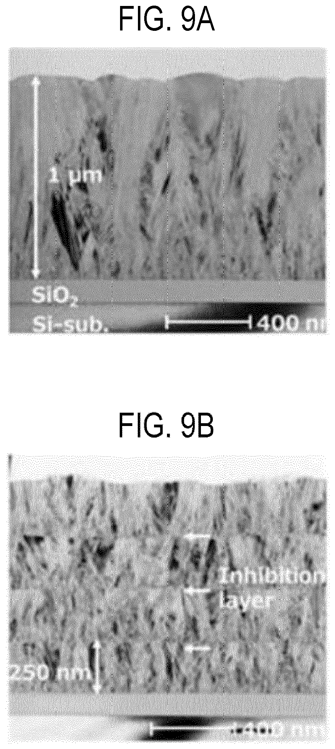

FIG. 9A shows a cross-sectional TEM image of Sample 1, and FIG. 9B shows a cross-sectional TEM image of Sample 3. A state of Sample 1 changes in a depth direction, irregular crystals are present near a base oxide film, and crystals grown into a columnar shape with a subsequent increase in film thickness are confirmed. In contrast, in Sample 3, it is confirmed that crystal growth is inhibited by a crystal growth inhibition layer and a crystallinity in a film thickness direction is uniform.

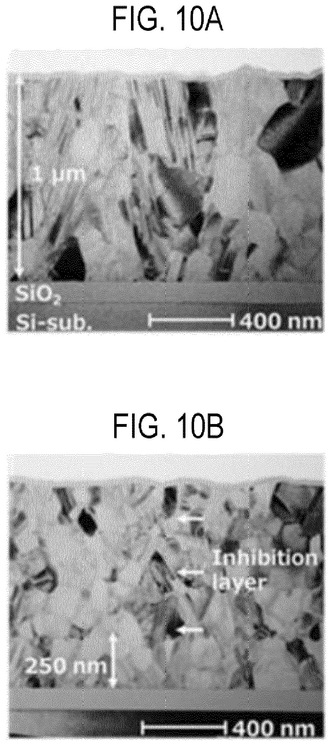

FIG. 10A shows a cross-sectional TEM image of Sample 2, and FIG. 10B shows a cross-sectional TEM image of Sample 4. It is confirmed that in Sample 2, the crystal grain size grows significantly by annealing, while in Sample 4, the crystal growth is suppressed by an inhibition layer even after annealing. Neither sample is single-crystallized by annealing. When excess Si atoms are incorporated into the crystal due to reduction in grain boundaries, it is expected that a compressive stress caused by the excess Si atoms may also decrease. In this case, as the annealing temperature becomes higher, the greater the decrease in compressive stress becomes larger.

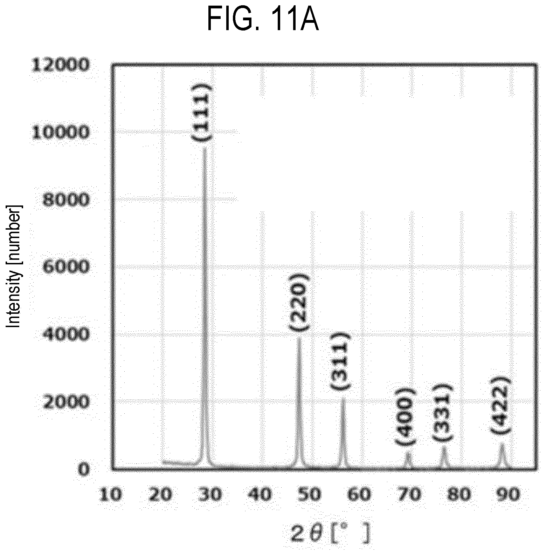

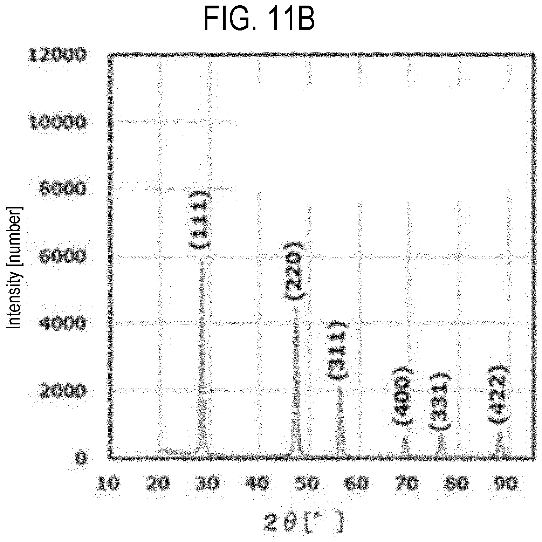

FIG. 11A is a diagram showing the XRD spectrum of Sample 2, and FIG. 11B is a diagram showing the XRD spectrum of Sample 4. Both are measured by an in-plane method. It is confirmed that in Sample 2, there is a strong intensity of (111) and a clear crystal orientation compared to the spectrum from a powder. On the other hand, in evaluated Sample 4, there is an orientation, but a proportion of (111) is smaller than that of Sample 1. This is thought to be because crystals of (111), which grow with the increase in film thickness, are inhibited from growing.

(Experiment 4)

In Experiment 4, a 25 $\mu$m-multilayer film is formed under the above-mentioned two conditions on both sides of a 200 mm-Si wafer with 2 $\mu$m-thick bases $SiO_2$ formed on both sides as sacrificial layers by using the above-described substrate processing apparatus. Samples 1 and 2 are fabricated under the first condition. That is, as shown in FIG. 8A, as a film-forming process of a comparative example, a process of forming a doped Si film 600a with a thickness of 25 nm on a sacrificial layer 300 by using a Si-containing gas added (doped) with $PH_3$ and a process of forming a non-doped Si film 600b with a thickness of 225 nm without being added with $PH_3$ are performed 100 times to form a polycrystalline film 600. Samples 3 and 4 are manufactured under the second condition. That is, as shown in FIG. 8B, a polycrystalline film 600 is formed by an ILIS process in which an $O_2$ gas is supplied to form a crystal growth inhibition layer 500 each time a process of forming a doped Si film 600a with a thickness of 25 nm on the sacrificial layer 300 by using a Si-containing gas added with $PH_3$ and a process of forming a non-doped Si film 600b with a thickness of 225 nm without being added with $PH_3$ are performed.

Then, Samples 1 and 3 are subjected to an annealing process at 900 degrees C for 60 minutes in a $N_2$ gas atmosphere. Further, Samples 2 and 4 are subjected to an annealing process at 1,100 degrees C for 5 minutes in a $N_2$ gas atmosphere. Then, steps of a lithography, a deep reactive ion etching, and removal of the sacrificial layer are performed on each of Samples 1 to 4 to form and evaluate various cantilevers with a width of 18 $\mu$m and a length of 100 to 700 $\mu$m.

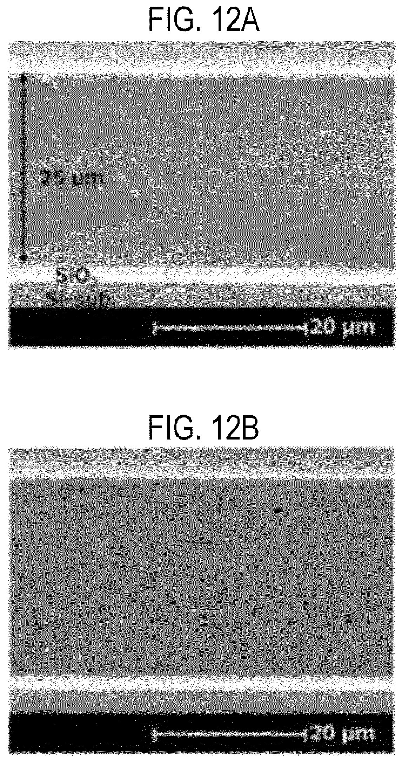

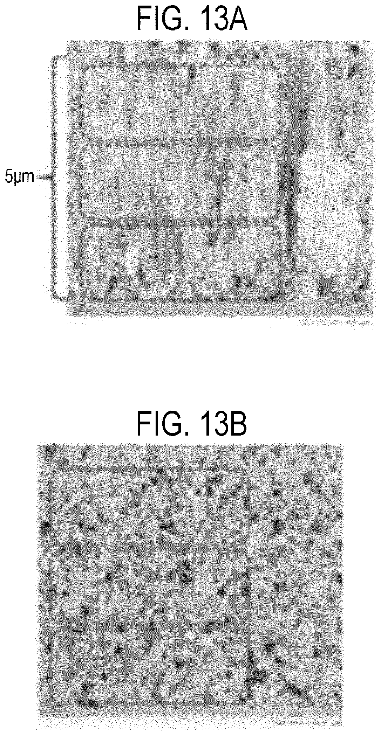

FIG. 12A is a cross-sectional SEM image of Sample 2, and FIG. 12B is a cross-sectional SEM image of Sample 4. To confirm a depth-dependent crystallinity in the cross-section, a region within 5 $\mu$m from an interface of a base $SiO_2$ is analyzed by EBSD. As shown in each of FIGS. 13A and 13B, an observation field of view of the EBSD analysis is set to three divided regions: top, center, and bottom, which are obtained by dividing the region within 5 $\mu$m from the interface.

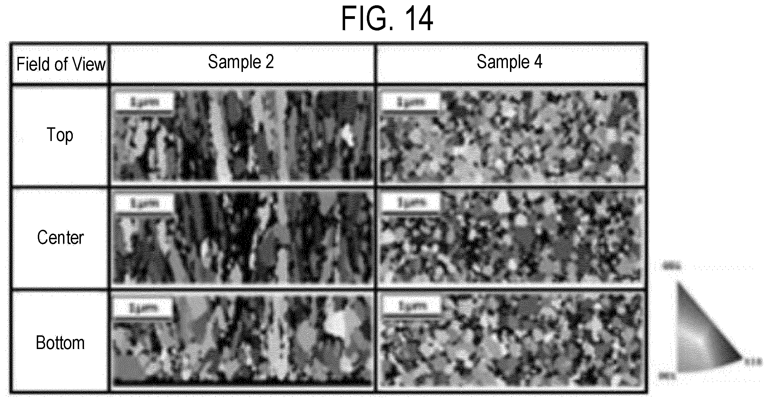

FIG. 14 is an inverse pole figure orientation map of Samples 2 and 4. This inverse pole figure shows a crystal orientation at each position in the field of view as a shade corresponding to a surface index of a crystal surface perpendicular to a cross section of the sample. The crystal grain size in each field of view calculated from this map is shown in Table 1 below. Note that the grain size is calculated as a weighted average grain size ($\mu$m) based on an area ratio, and a boundary of twin crystals is not considered as a grain boundary in this calculation.

[Table 1]

| Field of View | Sample 2 | Sample 4 |
|---|---|---|
| Top | 0.46 | 0.16 |
| Center | 0.38 | 0.17 |
| Bottom | 0.32 | 0.17 |

From Table 1, it may be seen that the crystal grain size of Sample 2 increases with film growth, but the crystal grain size of Sample 4 does not depend on the depth direction. Further, it may be seen that shapes of crystals of Sample 2 are different in the depth direction, while crystals of Sample 4 are suppressed from growing and is made to be uniform in the depth direction.

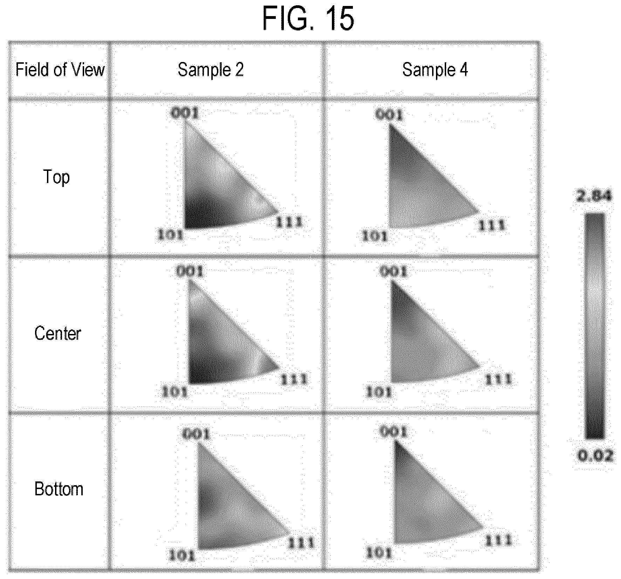

FIG. 15 is an inverse pole figure map of Samples 2 and 4. This map shows proportions of crystal surfaces in the respective fields of view in shades of a unit triangle of a stereographic projection. As also can be seen from FIG. 15, a distribution of crystal orientation in Sample 2 is not uniform in the depth direction, but a distribution of crystal orientation in Sample 4 is uniform in the depth direction. From these results, it can be seen that Sample 4 fabricated by the ILIS process is more uniform in crystal grain size, crystal shape, and crystal orientation in the depth direction than Sample 2 of the comparative example. Therefore, it is expected that a density of the excess Si is also uniform and a stress gradient is small.

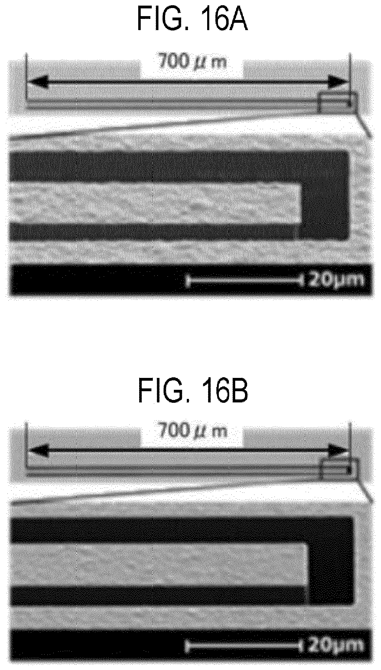

FIG. 16A is a view showing a SEM image of a cantilever made of Sample 2. FIG. 16B is a view showing a SEM image of a cantilever made of Sample 4. Two types of simple cantilever beams with lengths of 700 $\mu$m and 500 $\mu$m respectively are evaluation objects of the cantilever, and FIGS. 16A and 16B respectively show the cantilever beam with the length of 700 $\mu$m.

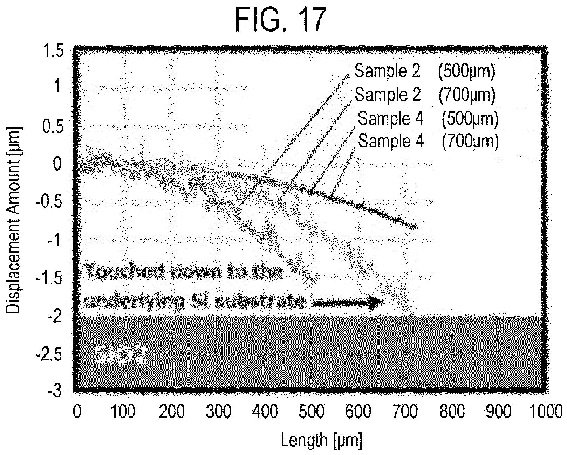

FIG. 17 is a diagram showing a profile of a displacement amount of a surface of the cantilever. As shown in, for the displacement amount, a displacement in a direction perpendicular to the wafer 200 is measured by using a white light interferometer. The 700 $\mu$m-cantilever of Sample 2 shown in FIG. 16A warps significantly such that it touches the Si substrate, and a pressure gradient is calculated from the 500 $\mu$m-cantilever. On the other hand, the 700 $\mu$m-cantilever of Sample 4 shown in FIG. 16B shows a profile almost identical to that of the 500 $\mu$m-cantilever, and it is confirmed that a tip of the cantilever is displaced downward by 0.8 $\mu$m and the calculated pressure gradient is - 0.65 MPa/$\mu$m, which is very small. This shows that the ILIS acts to alleviate the pressure gradient. A stress gradient X is calculated from the following equation.

[Eq. 1]

$$X = \frac{2uE}{L^2\,(1-v)}$$

In the above equation, u is an amount of vertical change of the cantilever, L is a length of the cantilever, E is Young's modulus, v is the Poisson's ratio of polysilicon (a known value of 0.22), and the Young's modulus is obtained by measuring a polycrystalline film of a sample with a nanoindenter.

Table 2 below shows indices of Sample 2, Sample 4, and a known Epi-poly Si film. A residual stress is calculated by measuring a longitudinal displacement of the tip of the cantilever (i.e., expansion and contraction of the cantilever) by using a rotating beam structure and multiplying the measured longitudinal displacement by Young's modulus. A surface roughness is measured as an arithmetic mean roughness by using an atomic force microscopy (AFM). Resistivity is measured by using a spreading resistance profiling (SRP).

[Table 2]

|  | Sample 4 | Sample 2 | Epi-poly Si |
|---|---|---|---|
| Stress gradient (Mpa/$\mu$m) | - 0.65 | - 2.61 | 1.41 |
| Residual stress (Mpa) | - 6.5 | - 40.9 | - 57.2 |
| Surface roughness Ra (nm) | 18 | 61 | 202 |
| Young's modulus (GPa) | 156.4 | 157.5 | - |
| Resistivity ($\Omega\cdot$cm) | 0.128 | 0.027 | 0.003 |

An absolute value of the stress gradient X of Sample 4 is smaller than that of Sample 2. Further, an absolute value of the residual stress of Sample 4 is smaller than that of Sample 2. Further, the surface roughness of Sample 4 is smaller than that of Sample 2. In other words, by inhibiting crystal growth with a crystal growth inhibition layer and forming uniform crystallinity in the depth direction, it is possible to reduce the absolute value of the residual stress and the stress gradient, and the surface roughness is also reduced. From the above, it is confirmed that by forming the crystal growth inhibition layer, it is possible to reduce the warping of the polysilicon film of the cantilever structure, and apply the polysilicon film to MEMS. The resistivities of both Samples 2 and 4 are inferior to that of the known Epi-poly Si film and Sample 4 shows greater deterioration. This may be due to insufficient optimization of the process conditions as well as enlargement of the crystal grain size. Since the ILIS in this example is a technique based on the well-known LPCVD poly-Si, the resistivity may be easily adjusted.

EXPLANATION OF REFERENCE NUMERALS

121: controller (control part), 200: wafer (substrate)

**Claims**

1. A method of processing a substrate, comprising:

    forming a multilayer film with a predetermined thickness on the substrate by performing a cycle a predetermined number of times, the cycle including:

    (a) depositing a primitive film by exposing the substrate to a precursor gas; and
    (b) exposing the substrate to a crystal growth inhibition gas or a predetermined gas that forms a film with a different film quality from the primitive film,

    wherein the predetermined number of times is set such that an absolute value or a gradient of a residual stress of the multilayer film after annealing the multilayer film is smaller than an allowable value.

2. The method of Claim 1, wherein in (a), a polycrystalline film is deposited as the primitive film, and

wherein (b) is performed under a condition where the polycrystalline film that is deposited in a subsequent (a) forms new crystal grains.

3. The method of Claim 1, wherein the primitive film contains a group XIV element.

4. The method of Claim 1, wherein in (b), by exposing the substrate to the crystal growth inhibition gas, crystal nuclei are provided at a predetermined density to the primitive film that is deposited in a subsequent (a).

5. The method of Claim 1, wherein the crystal growth inhibition gas is an oxygen-containing gas.

6. The method of Claim 1, wherein the predetermined gas contains a group XIV element, and a constituent element of the primitive film and a constituent element of the film with the different film quality from the primitive film are substantially the same.

7. The method of Claim 1, wherein (a) and (b) are performed at a same temperature.

8. The method of Claim 1, wherein in (b), a layer containing an element other than an element constituting the primitive film is formed on a surface of the primitive film formed in an immediately preceding (a).

9. The method of Claim 5, wherein (b) is performed under a process condition where an oxygen concentration in the film with the different film quality from the primitive film after the annealing is less than $1\times10^{23}$ [atoms/cm$^3$].

10. The method of Claim 6, wherein the primitive film is a polycrystalline film, and the film with the different film quality from the primitive film is an amorphous film.

11. The method of Claim 1, wherein a thickness of the film or a layer formed in (b) is smaller than a thickness of the primitive film formed in an immediately preceding (a).

12. The method of Claim 11, wherein the thickness of the film or the layer formed in (b) is 1/10 or less of the thickness of the primitive film formed in the immediately preceding (a).

13. The method of Claim 1, wherein the predetermined number of times is set to be greater as the residual stress after the annealing increases and to be smaller as the residual stress decreases.

14. The method of Claim 1, further comprising (c) annealing the multilayer film at a temperature of 1,200 degrees C or less, wherein in (c), the multilayer film is modified such that the absolute value of the residual stress after the annealing decreases as the predetermined number of times increases from 0.

15. The method of Claim 14, wherein the crystal growth inhibition gas is an oxygen-containing gas,

wherein a maximum value of an oxygen concentration in the multilayer film after (c) is between $1\times10^{20}$ and $1\times10^{22}$ [atoms/cm$^3$], and
wherein an oxygen concentration in the primitive film after (c) is less than $1\times10^{18}$ [atoms/cm$^3$].

16. The method of Claim 14, wherein the substrate before a first (a) is performed includes a sacrificial layer on a surface of the substrate, and
wherein the method further comprising (d) removing the sacrificial layer after (c).

17. A method of processing a substrate, comprising:

(a) in a process chamber, exposing a single crystal substrate including an oxide film formed on a surface of the single crystal substrate to a first element-containing gas, and depositing a polycrystalline film containing a first element on the surface in such a manner that at least a portion of crystal grains are epitaxial on the single crystal substrate; and
(b) processing the polycrystalline film into a cantilever while maintaining a stress gradient of the polycrystalline film within a predetermined range,

wherein (a) includes changing a partial pressure of the first element-containing gas or a partial pressure of a gas which is different from the first element-containing gas and used with the first element-containing gas during the exposure, or a temperature of the single crystal substrate such that a crystallinity remains constant during the deposition.

18. A method of manufacturing a semiconductor device comprising:

forming a multilayer film with a predetermined thickness on the substrate by performing a cycle a predetermined number of times, the cycle including:

(a) depositing a primitive film by exposing the substrate to a precursor gas; and
(b) exposing the substrate to a crystal growth inhibition gas or a predetermined gas that forms a film with a different film quality from the primitive film,

wherein the predetermined number of times is set such that an absolute value or a gradient of a residual stress of the multilayer film after annealing the multilayer film is smaller than an allowable value.

19. A substrate processing apparatus comprising:

a process chamber in which a substrate is processed;
a precursor gas supply system configured to expose the substrate in the process chamber to a precursor gas;
a crystal growth inhibition gas supply system configured to expose the substrate in the process chamber to a crystal growth inhibition gas or a predetermined gas supply system configured to expose the substrate to a predetermined gas, the predetermined gas forming a film with a different film quality from a primitive film deposited by exposing the substrate to the precursor gas; and
a controller configured to be capable of controlling any one of the precursor gas supply system, the crystal growth inhibition gas supply system, and the predetermined gas supply system so as to perform a process in the process chamber, the process including:
forming a multilayer film with a predetermined thickness on the substrate by performing a cycle a predetermined number of times, the cycle including:

(a) depositing the primitive film by exposing the substrate to the precursor gas; and
(b) exposing the substrate to the crystal growth inhibition gas or the predetermined gas,

wherein the predetermined number of times is set such that an absolute value or a gradient of a residual stress of the multilayer film after annealing the multilayer film is smaller than an allowable value.

20. A program that causes, by a computer, a substrate processing apparatus to perform a process in a process chamber of the substrate processing apparatus, the process comprising:

forming a multilayer film with a predetermined thickness on a substrate by performing a cycle a predetermined number of times, the cycle including:

(a) depositing a primitive film by exposing the substrate to a precursor gas; and
(b) exposing the substrate to a crystal growth inhibition gas or a predetermined gas that forms a film with a different film quality from the primitive film,

wherein the predetermined number of times is set such that an absolute value or a gradient of a residual stress of the multilayer film after annealing the multilayer film is smaller than an allowable value.

# FIG. 1

# FIG. 2

248

MFC — 241a~241h

Valve — 243a~243h

Pressure sensor — 245

APC valve — 244

Vacuum pump — 246

Heater — 207

Temperature sensor — 263

. . . .

Rotator — 267

Boat elevator — 115

Shutter opening/closing mechanism — 115s

121

121a

CPU

121b

RAM

123

External memory

121c

Memory

122

Input/output device

121d

I/O port

121e

# FIG. 3

```
        ┌─────────┐
        │  Start  │
        └─────────┘
             │
             ▼
┌────────────────────────────────┐
│        Film-forming step        │ ─── S110
└────────────────────────────────┘
             │
             ▼
┌────────────────────────────────┐
│         Annealing step          │ ─── S120
└────────────────────────────────┘
             │
             ▼
┌────────────────────────────────┐
│         Patterning step         │ ─── S130
└────────────────────────────────┘
             │
             ▼
┌────────────────────────────────┐
│  Sacrificial-layer-removing step │ ─── S140
└────────────────────────────────┘
             │
             ▼
        ┌─────────┐
        │   End   │
        └─────────┘
```

FIG. 4A

FIG. 4B

FIG. 5

EP 4 524 287 A1

# FIG. 6

EP 4 524 287 A1

# FIG. 7

Legend:
- ●— Annealing step present
- ○— Annealing step absent

THK=1um

Y-axis: Residual stress [MPa]
X-axis: The number of times crystal growth inhibition gas is supplied per 1μm

# FIG. 8A

600 { 600b, 600a, 600b, 600a, 600b, 600a }, 300, 200

# FIG. 8B

600 { 600b, 600a, 500, 500, 600b, 600a }, 300, 200

# FIG. 9A

# FIG. 9B

## FIG. 10A

## FIG. 10B

FIG. 11A

# FIG. 11B

## FIG. 12A

## FIG. 12B

## FIG. 13A

5µm

## FIG. 13B

## FIG. 14

| Field of View | Sample 2 | Sample 4 |
|---|---|---|
| Top | | |
| Center | | |
| Bottom | | |

# FIG. 15

| Field of View | Sample 2 | Sample 4 |
|---|---|---|
| Top | | |
| Center | | |
| Bottom | | |

## FIG. 16A

## FIG. 16B

FIG. 17

## INTERNATIONAL SEARCH REPORT

| International application No. |
|---|
| **PCT/JP2023/012014** |

**A. CLASSIFICATION OF SUBJECT MATTER**

***C23C 16/455***(2006.01)i; ***C23C 16/24***(2006.01)i; ***C23C 16/52***(2006.01)i; ***H01L 21/205***(2006.01)i
FI: C23C16/455; H01L21/205; C23C16/52; C23C16/24

According to International Patent Classification (IPC) or to both national classification and IPC

**B. FIELDS SEARCHED**

Minimum documentation searched (classification system followed by classification symbols)

C23C16/455; C23C16/24; C23C16/52; H01L21/205

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 63-260052 A (NIPPON TELEGR & TELEPH CORP <NTT>) 27 October 1988 (1988-10-27) | 1-3, 6, 10-14, 18-20 |
| | specification, p. 2, lower left column to p. 3, upper left column, fig. 3 | |
| Y | | 16 |
| A | | 4, 5, 7-9, 15, 17 |
| X | JP 61-182221 A (AMERICAN TELEPHONE AND TELEGRAPH COMPANY) 14 August 1986 (1986-08-14) | 1-4, 6, 7, 11-14, 18-20 |
| | specification, p. 6, columns 19-22, fig. 3 | |
| Y | | 16 |
| A | | 5, 8-10, 15, 17 |
| X | JP 2020-526920 A (APPLIED MATERIALS INC) 31 August 2020 (2020-08-31) | 1, 3, 8, 13, 14, 18-20 |
| | paragraphs [0010]-[0012], fig. 2 | |
| A | | 2, 4-7, 9-12, 15-17 |

☑ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 June 2023** | **13 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2023/012014**

**C.    DOCUMENTS CONSIDERED TO BE RELEVANT**

| Category* | Citation of document, with indication, where appropriate, of the relevant passages | Relevant to claim No. |
|---|---|---|
| X | JP 10-508908 A (FRAUNHOFER-GESELLSCHAFT ZUR FORDERUNG DER ANGEWANDTEN FORSCHUNG E.V) 02 September 1998 (1998-09-02) specification, p. 7, line 27 to p. 8, line 14, fig. 3 | 17 |
| Y | | 16 |
| A | | 1-15, 18-20 |

**INTERNATIONAL SEARCH REPORT**
Information on patent family members

International application No.

**PCT/JP2023/012014**

| Patent document cited in search report | | | Publication date (day/month/year) | Patent family member(s) | | Publication date (day/month/year) |
|---|---|---|---|---|---|---|
| JP | 63-260052 | A | 27 October 1988 | (Family: none) | | |
| JP | 61-182221 | A | 14 August 1986 | US 4742020 A<br>specification, column 8, line 40<br>to column 9, line 43, fig. 4 | | |
| JP | 2020-526920 | A | 31 August 2020 | WO 2019/010196 A1<br>paragraphs [0024]-[0026], fig. 2<br>EP 3649670 A1<br>TW 201907449 A<br>KR 10-2020-0016397 A<br>CN 110892504 A<br>SG 11201912265W A<br>US 2019/0013250 A1 | | |
| JP | 10-508908 | A | 02 September 1998 | US 7919345 B1<br>specification, column 3, line 61<br>to column 4, line 18, fig. 3<br>WO 1996/016203 A1<br>DE 4445177 A<br>DE 4445177 A1<br>AT 184920 T | | |

Form PCT/ISA/210 (patent family annex) (January 2015)

## REFERENCES CITED IN THE DESCRIPTION

**Patent documents cited in the description**

- JP 2020043262 A
- JP 2016001760 A
- JP 2009081457 A
- JP 2013197307 A
- JP 2009147388 A
- JP 2018160516 A
- WO 2022064578 A